# EUROPEAN PATENT APPLICATION

(11) **EP 1 873 275 A2**
(43) Date of publication of application: **02.01.2008**
(21) Application number: 07111237.9
(22) Date of filing: 28.06.2007
(51) Int. Cl.: C23C 16/455

(54) **Showerhead for a gas supply apparatus**

(30) Priority: 29.06.2006 US 427473
(71) Applicant: Aviza Technology, Inc., Scotts Valley, CA 95066 (US)
(72) Inventor: Bailey, Robert Jeffrey, Scotts Valley, CA 95066 (US); Dedontney, Jay Brian, Prunedale, CA 93907 (US)
(74) Representative: HOEIBERG A/S

(57) **Abstract**

A showerhead for a gas supply apparatus. This showerhead includes a body having a distribution plate on one side and at least one gas chamber contained within the body. A plurality of holes extend normally from an outer surface of the distribution plate to the chamber. Furthermore, at least a portion of at least one hole is frustoconical or frustopyramidal in shape along the normal axis with the base of the frustoconical or frustopyramidal hole positioned adjacent the outer surface of the distribution plate.

## Description

### BACKGROUND OF THE INVENTION

### I. FIELD OF THE INVENTION

The present invention relates to a showerhead for a gas supply apparatus.

### II. DESCRIPTION OF RELATED ART

There are different manufacturing apparatuses for a manufacturer of semiconductor devices. In one such apparatus, the semiconductor wafer is supported within a reaction chamber while a showerhead gas injection manifold is positioned over and above the wafer. The showerheads include a body having a distribution plate with an outer surface positioned above the wafer and at least one internal gas chamber.

A plurality of holes is formed through the distribution plate to the gas chamber. Consequently, when the reaction gas or gases are supplied to the showerhead chamber, these gases flow out through the holes in the distribution plate and onto the wafer.

Showerheads can be used for different methods of semiconductor processing. For example, showerheads may be used in either a steady-state condition, e.g. CVD, or a pulsed reactant, e.g. ALD, mode of operation. Regardless of the mode of operation, it is usually desirable that the gas flow velocities be highly uniform between the showerhead distribution plate and the wafer to avoid undesirable effects such as excessive gas phase reaction that can lead to particle formation or heavy powdering on the surface of the showerhead.

Both of these adverse effects, particle formation or powdering on the surface of the showerhead, are exacerbated by turbulence and central air recirculation of the gas above the wafer. Furthermore, the presence of recirculation indicates a lack of control over the gas residence time and undesirable particle-forming reactions can occur. Furthermore, in most semiconductor processing situations, it is best to avoid direct impingement of the gases from each showerhead hole onto the wafer prior to intermixing with the gas flow from adjacent holes.

The previously known showerheads are typically perforated by small diameter holes that may restrict the gas flow sufficiently to yield essentially equal gas flow from each outlet hole. These small diameter outlet holes, however, can result in high-velocity jets of gas emerging from the showerhead and onto the wafer. Under certain high-velocity flow from the showerhead holes, the gases from each showerhead hole may undesirably impinge on the wafer's surface prior to intermixing with the gas flow from adjacent holes. This, in turn, can generate gas recirculation cells within the reaction chamber through forced convection.

Conversely, under other conditions, such as low flow rates, low pressures, large showerhead to wafer distance and the like, the gases from the same showerhead intermix with the gases from adjacent holes in the showerhead to form a substantially uniform front of gas flow onto the wafer in a desired fashion.

Each showerhead has its own design specifications. These specifications include not only the diameter of the holes flowing through the showerhead, but also the spacing of the holes relative to each other. However, due to the nature of the gas flow dynamics through the holes in the showerhead, the showerhead design that is acceptable for one process condition may be entirely unacceptable for other processing conditions.

### SUMMARY OF THE PRESENT INVENTION

The present invention provides a showerhead for a gas supply apparatus of the type used in semiconductor processing which overcomes the above-mentioned disadvantages of the previously known showerheads.

In brief, the showerhead of the present invention comprises a body having a distribution plate on one side. At least one gas chamber is contained within the body.

A plurality of holes extend normally from an outer surface of the distribution plate to the chamber formed within the body of the showerhead. Furthermore, at least a portion of at least one hole, and preferably all holes, is frustoconical in shape along the normal axis with the base of the frustoconical holes positioned at or adjacent the outer surface of the distribution plate.

The frustoconical shape of the holes in the showerhead distribution plate enhances the intermixing of the gases from each hole with the gases from the adjacent holes in high pressure applications. This, in turn, minimizes or at least reduces the likelihood of impingement of the gases from any single hole in the showerhead on the processed wafer during high-pressure/high-velocity applications.

### BRIEF DESCRIPTION OF THE DRAWING

A better understanding of the present invention will be had upon reference to the following detailed description when read in conjunction with the accompanying drawings, wherein like reference characters refer to like parts throughout the several views, and in which:
FIG. 1 is a side diagrammatic view illustrating a preferred embodiment of the showerhead of the present invention in a gas reaction device;
FIG. 2 is a fragmentary sectional view taken along circle 2-2 in FIG. 1 and enlarged for clarity;
FIG. 3 is a fragmentary plan view taken along line 3-3 in FIG. 2;
FIG. 4 is a view similar to FIG. 2, but illustrating a modification thereof;
FIG. 5 is a view similar to FIG. 2, but illustrating a further modification thereof; and
FIG. 6 is a fragmentary plan view taken along line 6-6 in FIGS. 5.

### DETAILED DESCRIPTION OF A PREFERRED EMBODIMENT OF THE PRESENT INVENTION

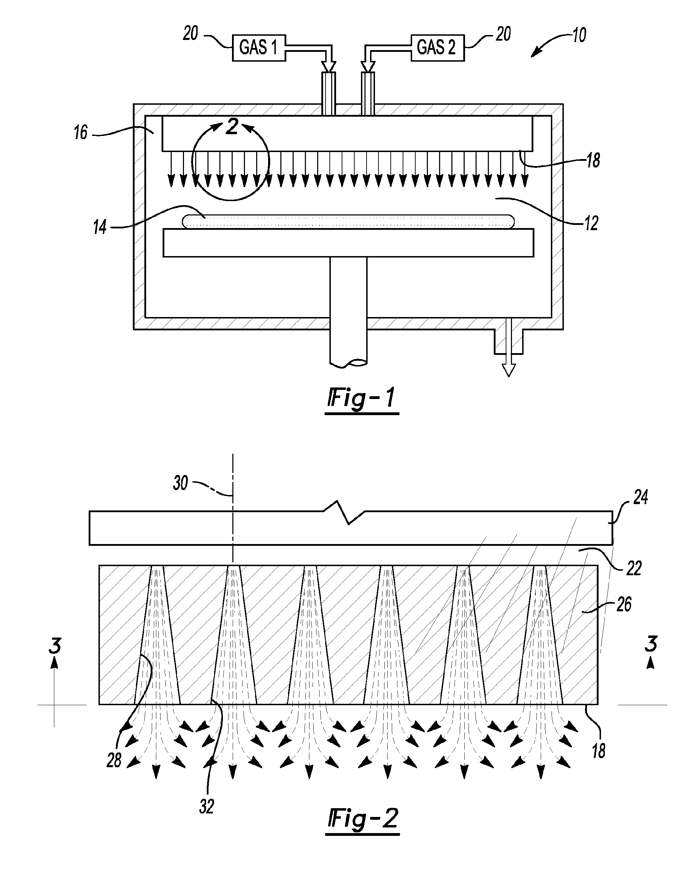

With reference first to FIG. 1, a reaction device of the type used for semiconductor processing is illustrated diagrammatically. The device 10 includes a reaction chamber 12 in which a semiconductor wafer 14 is supported. A showerhead 16 is also positioned within the reaction chamber 12 and includes a distribution plate 18 positioned away from but generally parallel to the wafer 14.

At least one, and oftentimes two or more, reaction gas supplies 20 are fluidly connected to manifolds contained within the showerhead 16. These manifolds in turn form gas chambers for the reaction gas 20.

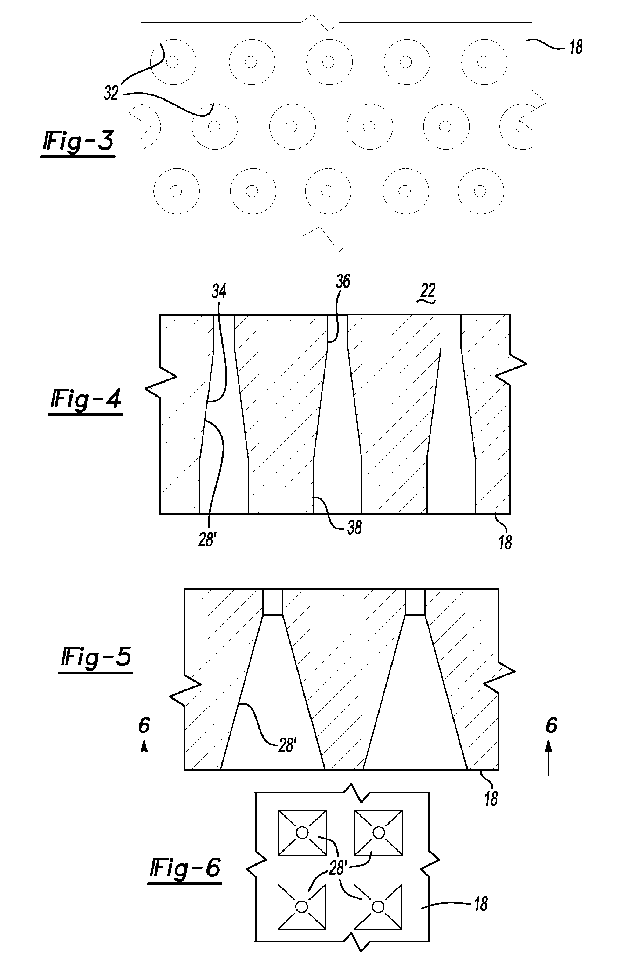

With reference now particularly to FIGS. 2 and 3, the showerhead 16 includes a body 24 having a lower distribution plate with the outer lower surface 18. The gas chamber 22 is formed within the body 24 and clearly connected by conventional means to one or more reaction gas sources 20.

A plurality of spaced holes 28 is formed normally along a normal axis 30 through the distribution plate 26 from the outer surface 18 and to the gas chamber 22. At least one, and preferably all, of the holes 28 are frustoconical in shape along the normal axis 30 with the base of each hole 28 positioned adjacent the outer surface 18 of the distribution plate 26. Optionally, the holes 28" may be frustopyramidal in shape as shown in FIGS. 5 and 6 to minimize the surface area of the outer surface of the plate 18.

As best shown in FIG. 2, each hole 28 is illustrated as having its base 32 aligned with the outer surface 18 of the distribution plate 26 and its apex open to the reaction gas chamber 22. However, other configurations are alternatively possible.

For example, as shown in FIG. 4, each hole 28' includes a frustoconical central portion 34 with a cylindrical section 36 connecting the frustoconical portion 34 with the reaction gas chamber 22 and a further cylindrical portion 38 fluidly connecting the frustoconical portion 34 with the outer surface 18 of the distribution plate 26. Consequently, it is only necessary that a portion of the hole 28' be frustoconical in shape.

In practice, the frustoconical or frustopyramidal shape of the holes 28 in the showerhead distribution plate 26 ensures intermixing of the gases with the gas flow from adjacent holes even in high-pressure applications. As such, direct impingement of the gases from any single showerhead hole 28 is avoided, thus minimizing gas recirculation within the reaction chamber 12.

Such intermixing of the gases from each hole 28 with the gases from the adjacent hole prior to impingement on the wafer 14 is also accomplished in low-pressure applications. Consequently, the showerhead 16 of the present invention may be utilized in a variety of different applications and processing modes without the previously known undesirable direct impingement of the gases from any individual holes onto the wafer 14 and the resulting undesirable recirculation of gases within the reaction chamber 12.

From the foregoing, it can be seen that the present invention provides a showerhead gas distribution manifold for use in semiconductor processing which overcomes the disadvantages of the previously known showerhead gas distribution manifolds. Having described my invention, however, many modifications thereto will become apparent to those skilled in the art to which it pertains without deviation from the spirit of the invention as defined by the scope of the appended claims.

## Claims

1. A showerhead for a gas supply apparatus comprising:
a body having a distribution plate on one side,
at least one chamber contained within said body,
a plurality of holes extending normally from an outer surface of said distribution plate to said at least one chamber,
wherein at least a portion of at least one of said holes is frustoconical in shape along said normal axis with a base of the frustoconical hole positioned adjacent said outer surface of said distribution plate.

2. The invention as defined in claim 1 wherein said at least one hole comprises a plurality of said holes.

3. The invention as defined in claim 1 wherein said base of the frustoconical hole is aligned with said outer surface of said distribution plate.

4. A showerhead for a gas supply apparatus comprising:
a body having a distribution plate on one side,
at least one chamber contained within said body,
a plurality of holes extending normally from an outer surface of said distribution plate to said at least one chamber,
wherein at least a portion of at least one of said holes is frustopyramidal in shape along said normal axis with a base of the frustopyramidal hole positioned adjacent said outer surface of said distribution plate.

5. The invention as defined in claim 4 wherein said at least one hole comprises a plurality of said holes.

6. The invention as defined in claim 4 wherein said base of the frustopyramidal hole is aligned with said outer surface of said distribution plate.
